# EUROPÄISCHE PATENTSCHRIFT

(11) **EP 0 543 275 B1**
(45) Veröffentlichungstag und Bekanntmachung des Hinweises auf die Patenterteilung: **11.09.1996**
(21) Anmeldenummer: 92119303.3
(22) Anmeldetag: 11.11.1992
(51) Int. Cl.: H03F 3/60, H03F 3/191, H03F 3/45

(54) **Breitband-Verstärkerstufe mit zwei gleichphasigen, entkoppelten Ausgangsanschlüssen**
Broad-band amplifier stage with two in-phase decoupled output terminals
Etage amplificateur à large bande à deux terminaux de sortie découplés et en phase

(30) Priorität: 19.11.1991 DE 4138051
(43) Veröffentlichungstag der Anmeldung: 26.05.1993
(73) Patentinhaber: SIEMENS AKTIENGESELLSCHAFT, 80333 München (DE)
(72) Erfinder: Meyer, Fritz, Dr.-Ing., W-8034 Germering (DE)

(56) Entgegenhaltungen:
- US-A- 3 743 863
- US-A- 4 465 979
- US-A- 4 797 628
- IBM TECHNICAL DISCLOSURE BULLETIN, Bd. 9, Nr. 6, November 1966, New York, US, S. 710; T.I. KIRKPATRICK: 'Transformer-loaded differential amplifier'

## Beschreibung

Die Erfindung betrifft eine Breitband-Verstärkerstufe entsprechend dem Oberbegriff des Patentanspruchs 1.

Zur Versteilerung und Verstärkung impulsförmiger Signale eignen sich bekanntlich wegen ihrer relativ großen Bandbreite emittergekoppelte Differenzverstärker recht gut. Sie gestatten auch auf einfache Weise einen Abgleich von Amplitude und Tastverhältnis der Impulse beispielsweise zur Einstellung vorgegebener Impulsformen für die sogenannten Augendiagramme. Werden jedoch beispielsweise zur Auffächerung von Ausgangssignalen mehrere solcher Differenzverstärker in einer Baugruppe benötigt, dann steigt die Leistungsaufnahme entsprechend an, so daß neben der hohen Leistungsaufnahme auch der Aufwand für Kühlmaßnahmen beispielsweise innerhalb einer Baugruppe stören kann. Die Erzeugung von gleichphasigen Ausgangssignalen ist auch mit nur einem Differenzverstärker möglich, bei dem einem der Ausgänge eine Inverterstufe nachgeschaltet ist. Auch durch die Inverterstufe steigt aber die Leistungsaufnahme an. Wenn im Hinblick auf die gewünschte Stabilität bei hohen Frequenzen die Inverterstufe mittels eines Differenzverstärkers realisiert wird, ergibt sich kein Unterschied in Aufwand und Leistungsaufnahme zur Parallelschaltung von zwei Differenzverstärkern.

Aus IBM Technical Disclosure Bulletin, Bd. 9, Nr. 6, November 1966, New York, US, Seite 710, T.I. Kirkpatrick 'Transformer-Loaded Differential Amplifier' ist ein emitter gekoppelter Differenzverstärker mit einem Transformator als Last zur Unterdrückung von Gleichtaktsignalen bekannt. Aus US-A-4 797 628 ist für einen Push-Pull Verstärker die Verwendung eines Transformators zur Signalinvertierung bekannt.

Die Leistungsaufnahme von Verstärkern für niedrigere Frequenzen kann bekanntlich in einfacher Weise durch die Verwendung von Feldeffekttransistoren reduziert werden. Im vorliegenden Falle soll jedoch eine Verstärkerstufe mit einer Bandbreite von ca. 100 kHz bis zu etwa 2 GHz mit Ausgangsströmen von wenigstens 10 mA realisiert werden. Bei diesen Bedingungen ist jedoch die Verwendung von Feldeffekttransistoren nicht möglich.

Es müssen bipolare Transistoren mit Transitfrequenzen von etwa 5 GHz zur Anwendung kommen.

Die Aufgabe bei der Erfindung besteht also darin, eine Breitband-Verstärkerstufe der eingangs erwähnten Art anzugeben, die bei möglichst geringem Aufwand und geringer Leistungsaufnahme zwei zueinander gleichphasige Ausgangssignale erzeugt.

Erfindungsgemäß wird die Aufgabe durch eine Breitband-Verstärkerstufe der eingangs erwähnten Art gelöst, die durch die Merkmale des Patentanspruchs 1 weitergebildet ist. Von besonderem Vorteil bei der erfindungsgemäßen Breitband-Verstärkerstufe ist die Möglichkeit, ausschließlich npn-Transistoren verwenden zu können, so daß das durch die höherere Trägerbeweglichkeit bessere Schaltverhalten gegenüber pnp-Transistoren benützt werden kann und die benötigten Transistoren auch in einfacher Weise Teil einer integrierten Schaltung sein können. Die erfindungsgemäße Breitband-Verstärkerstufe kann in vorteilhafter Weise entsprechend dem Patentanspruch 2 auch im Gegentakt angesteuert werden, so daß sich die Umschaltgeschwindigkeit weiter erhöht. In den Patentansprüchen 3 bis 5 sind Breitband-Verstärkerstufen mit besonders einfach zu realisierenden Leitungsanordnungen beschrieben.

Die Erfindung soll im folgenden anhand eines in der Zeichnung dargestellten Ausführungsbeispiels näher erläutert werden.

Dabei zeigt:

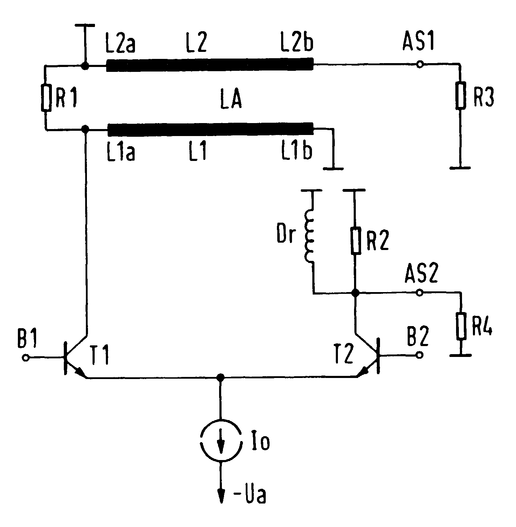

- Fig. 1: die Prinzipdarstellung einer erfindungsgemäßen Breitband-Verstärkerstufe mit zwei Abschlußwiderständen als Verbraucher.

In der Figur 1 sind ein erster und ein zweiter npn-Transistor T1, T2 zu einem emittergekoppelten Differenzverstärker zusammengeschaltet. Dabei sind die Emitteranschlüsse dieser Transistoren in bekannter Weise miteinander und über eine Stromquelle Io mit einer Betriebsspannungsquelle - Ua verbunden.

Die Spannungsteileranordnungen zur Erzeugung der Basisströme sind dabei wegen ihrer allgemeinen Bekanntheit weggelassen. Es kann wahlweise mit dem Basisanschluß B1 des ersten Transistors T1 ein einzelner Signaleingang und mit dem Basisanschluß B2 des zweiten Transistors T2 eine Referenzspannungsquelle angeschlossen werden, es kann aber auch zur Erhöhung der Umschaltgeschwindigkeit mit beiden Basisanschlüssen eine Signalquelle für eine Gegentaktansteuerung verbunden werden.

Der Kollektoranschluß des ersten Transistors T1 ist mit einem ersten Anschluß L1a eines ersten Leiters L1 einer Leitungsanordnung LA sowie über einen ersten Widerstand R1 mit Bezugspotential verbunden. Mit dem Anschlußpunkt für Bezugspotential ist außerdem der erste Anschluß L2a eines zweiten Leiters L2 verbunden, der zusammen mit dem ersten Leiter die Leitungsanordnung LA bildet. Die beiden ersten Anschlüsse L1a, L2a der Leiter sind dabei unmittelbar benachbart, ebenso die beiden zweiten Anschlüsse L1b, L2b der beiden Leiter. Der zweite Anschluß L1b des ersten Leiters L1 ist mit Bezugspotential verbunden, während der zweite Anschluß L2b des zweiten Leiters mit einem ersten Ausgangsanschluß AS1 verbunden ist.

Der Kollektoranschluß des zweiten Transistors T2 ist unmittelbar mit einem zweiten Ausgangsanschluß AS2 sowie über die Parallelschaltung aus einem zweiten Widerstand R2 und einer handelsüblichen Hochfrequenzdrossel Dr mit Bezugspotential verbunden. An die Ausgangsanschlüsse AS1, AS2 sind als Verbraucher ein dritter bzw. vierter Widerstand R3, R4 angeschlossen. Die Leitungsanordnung LA ist dabei auf der einen Seite durch den ersten Widerstand R1 und auf der anderen Seite durch den Verbraucherwiderstand R3 wenigstens annähernd reflexionsfrei abgeschlossen.

Der Kollektorstrom des ersten Transistors T1 speist die als Leitungsanordnung LA mit wechselseitig geerdeten Leitern, so daß am Ausgang dieser Leitungsanordnung und damit am ersten Ausgangsanschluß AS1 der Breitband-Verstärkerstufe das jeweilige Ausgangssignal mit einer Phasendrehung von 180 Grad bezogen auf das Signal am Kollektoranschluß des ersten Transistors T1 ansteht. Dabei bewirkt die Hauptinduktivität des aus den beiden gekoppelten Leitern L1, L2 gebildeten Übertragers, die am Ausgang parallel zum Innenwiderstand liegt, einen Kurzschluß der tiefen Frequenzen des Ausgangssignals nach Masse, so daß sich hieraus eine untere Grenzfrequenz für das Übertragungssignal bezogen auf den ersten Ausgangsanschluß AS1 ergibt.

Beim Ausführungsbeispiel wurde die Leitungsanordnung dadurch realisiert, daß vier Windungen einer Paralleldrahtleitung mit einem Wellenwiderstand von etwa 75 Ohm auf einen Ferritkern (Siemens B62152-A7-X30) aufgewickelt wurden, eine weitere Realisierungsmöglichkeit ergibt sich durch Verwendung einer Koaxialleitung anstelle der Paralleldrahtleitung. Durch die erwähnte Hauptinduktivität des Übertragers ergab sich eine untere Grenzfrequenz von etwa 50 kHz, bei Verwendung von Transistoren mit Transitfrequenzen von etwa 5 GHz konnte eine untere Grenzfrequenz von etwa 2 GHz erreicht werden.

Zur Ausgangsanpassung und zur Gleichstromzuführung ist der Kollektoranschluß des zweiten Transistors T2 über die Parallelschaltung des zweiten Widerstandes und der Drossel mit Bezugspotential verbunden. Durch die Drossel ergibt sich auch in diesem Falle für niedrigfrequente Signalanteile ein Kurzschluß gegen Masse, so daß auch dieser Teil der Breitband-Verstärkerstufe eine untere Grenzfrequenz aufweist. Durch Wahl eines bestimmten Induktivitätswertes für die Drossel ergibt sich eine untere Grenzfrequenz, die etwa der der durch die Leitungsanordnung LA verursachten unteren Grenzfrequenz entspricht. Auch am zweiten Ausgangsanschluß AS2 liegt also ein Breitbandsignal an, das etwa den Bereich zwischen 50 kHz und 2 GHz überdeckt.

Die Realisierung ergab neben dem erwünschten geringem Schaltungsaufwand und der geringen Leistungsaufnahme auch einen verringerten Platzbedarf gegenüber den eingangs erwähnten konventionellen Lösungen.

## Patentansprüche

1. Breitband-Verstärkerstufe für Signale bis in den Gigahertzbereich mit einem, einen ersten und einem zweiten Transistor enthaltenden emittergekoppelten Differenzverstärker und mit zwei voneinander entkoppelten Ausgangsanschlüssen,
**dadurch gekennzeichnet,**
daß der Kollektoranschluß des ersten Transistors (T1) mit einem ersten Anschluß (L1a) eines ersten Leiters (L1) einer Leitungsanordnung (LA) sowie über einen ersten Widerstand (R1) sowohl mit Bezugspotential als auch mit dem ersten Anschluß (L2a) eines zweiten Leiters (L2) der Leitungsanordnung (LA) verbunden ist, daß der zweite Anschluß (L1b) des ersten Leiters (L1) mit Bezugspotential und der zweite Anschluß (L2b) des zweiten Leiters (L2) mit einem ersten Ausgangsanschluß (AS1) verbunden ist, daß der Kollektoranschluß des zweiten Transistors (T2) mit einem zweiten Ausgangsanschluß (AS2) sowie über die Parallelschaltung einer Hochfrequenzdrossel (Dr) und eines zweiten Widerstandes (R2) mit Bezugspotential verbunden ist und daß jeweils sowohl die ersten Anschlüsse als auch die zweiten Anschlüsse der Leiter zueinander unmittelbar benachbart sind.

2. Breitband-Verstärkerstufe nach Patentanspruch 1,
**dadurch gekennzeichnet,**
daß die Basisanschlüsse (B1, B2) des ersten und des zweiten Transistors (T1, T2) mit einer Signalquelle für eine Gegentaktansteuerung verbunden sind.

3. Breitband-Verstärkerstufe nach Patentanspruch 1,
**dadurch gekennzeichnet,**
daß der erste und der zweite Leiter (T1, L2) zu einer Paralleldrahtleitung zusammengefaßt sind.

4. Breitband-Verstärkerstufe nach Patentanspruch 1,
**dadurch gekennzeichnet,**
daß der erste und der zweite Leiter (L1, L2) zu einer Koaxialleitung zusammengefaßt sind.

5. Breitband-Verstärkerstufe nach Patentansprüchen 1, 3 oder 4,
**dadurch gekennzeichnet,**
daß der erste und der zweite Leiter (L1, L2) auf einen ersten hochpermeablen Ferritkern aufgewickelt sind.

## Claims

1. Broadband amplifier stage for signals into the gigahertz range, having an emitter-coupled differential amplifier containing a first and a second transistor, and having two mutually decoupled output terminals, characterized in that the collector terminal of the first transistor (T1) is connected to a first terminal (L1a) of a first conductor (L1) of a line arrangement (LA) and is connected via a first resistor (R1) both to the reference potential and to the first terminal (L2a) of a second conductor (L2) of the line arrangement (LA), in that the second terminal (L1b) of the first conductor (L1) is connected to the reference potential and the second terminal (L2b) of the second conductor (L2) is connected to a first output terminal (AS1), in that the collector terminal of the second transistor (T2) is connected to a second output terminal (AS2) and is connected to the reference potential via the parallel circuit formed by a radio-frequency inductor (Dr) and a second resistor (R2), and in that both the first terminals and the second terminals of the conductors are in each case directly adjacent to one another.

2. Broadband amplifier stage according to Patent Claim 1, characterized in that the base terminals (B1, B2) of the first and of the second transistor (T1, T2) are connected to a signal source for push-pull driving.

3. Broadband amplifier stage according to Patent Claim 1, characterized in that the first and the second conductor (L1, L2) are combined to form a parallel-wire line.

4. Broadband amplifier stage according to Patent Claim 1, characterized in that the first and the second conductor (L1, L2) are combined to form a coaxial line.

5. Broadband amplifier stage according to Patent Claim 1, 3 or 4, characterized in that the first and the second conductor (L1, L2) are wound onto a first ferrite core of high permeability.

## Revendications

1. Etage d'amplificateur large bande de signaux de fréquence allant jusque dans le domaine du gigahertz, comportant un amplificateur différentiel comprenant des premier et second transistors et à émetteurs couplés, et deux bornes de sortie découplées l'une de l'autre,
caractérisé en ce que
la borne de collecteur du premier transistor (T1) est reliée à une première borne (L1a) d'un premier conducteur (L1) d'un dispositif (LA) de ligne ainsi que par l'intermédiaire d'une première résistance (R1) à la fois au potentiel de référence et à la première borne (L2a) d'un second conducteur (L2) du dispositif (LA) de ligne, la seconde borne (L1b) du premier conducteur (L1) est reliée au potentiel de référence et la seconde borne (L2b) du second conducteur (L2) est reliée à une première borne (AS1) de sortie, la borne de collecteur du second transistor (T2) est reliée à une seconde borne (AS2) de sortie ainsi que par l'intermédiaire du circuit en parallèle d'une bobine (Dr) d'arrêt haute fréquence et d'une seconde résistance (R2) au potentiel de référence et à la fois les premières et les secondes bornes des conducteurs sont en voisinage direct l'une par rapport à l'autre.

2. Etage d'amplificateur large bande suivant la revendication 1,
caractérisé en ce que
les bornes (B1, B2) de base des premier et second transistors (T1, T2) sont reliés à une source de signaux pour une commande push-pull.

3. Etage d'amplificateur large bande suivant la revendication 1,
caractérisé en ce que
les premier et second conducteurs (L1, L2) sont rassemblés en une ligne à fils parallèles.

4. Etage d'amplificateur large bande suivant la revendication 1,
caractérisé en ce que
les premier et second conducteurs (L1, L2) sont rassemblés en une ligne coaxiale.

5. Etage d'amplificateur large bande suivant la revendication 1, 3 ou 4,
caractérisé en ce que
le premier et le second conducteur (L1, L2) sont enroulés sur un premier noyau de ferrite de grande perméabilité.
